(19) Europäisches Patentamt / European Patent Office / Office européen des brevets

(11) **EP 2 409 167 B1**

(12) **FASCICULE DE BREVET EUROPEEN**

(45) Date de publication et mention de la délivrance du brevet:
**25.01.2017 Bulletin 2017/04**

(21) Numéro de dépôt: **10723162.3**

(22) Date de dépôt: **20.03.2010**

(51) Int Cl.:
*G06K 9/00* (2006.01)        *H02J 3/00* (2006.01)
*G01R 21/133* (2006.01)

(86) Numéro de dépôt international:
**PCT/FR2010/000233**

(87) Numéro de publication internationale:
**WO 2010/106253 (23.09.2010 Gazette 2010/38)**

(54) **PROCÉDÉ ET DISPOSITIF DE FILTRAGE DE COURBES DE CONSOMMATION ÉLECTRIQUE ET D'ALLOCATION DE CONSOMMATION À DES CLASSES D'APPAREILS**

VERFAHREN UND VORRICHTUNG ZUR FILTERUNG VON ENERGIEVERBRAUCHSKURVEN UND ZUWEISUNG DES VERBRAUCHS ZU GERÄTEKATEGORIEN

METHOD AND DEVICE FOR FILTERING ELECTRICAL CONSUMPTION CURVES AND ALLOCATING CONSUMPTION TO CATEGORIES OF APPLIANCES

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **20.03.2009 FR 0901311**

(43) Date de publication de la demande:
**25.01.2012 Bulletin 2012/04**

(73) Titulaire: **Université du Sud Toulon-Var 83957 La Garde Cedex (FR)**

(72) Inventeurs:
• **REBEC, Gaelle**
  **F-83220 Le Pradet (FR)**
• **LACROIX, Yves**
  **F-83400 Hyères (FR)**

(74) Mandataire: **Cabinet Camus Lebkiri
25 rue de Maubeuge
75009 Paris (FR)**

(56) Documents cités:
**US-A- 4 858 141**

• **LESLIE K NORFORD ET AL: "Non-intrusive electrical load monitoring in commercial buildings based on steady-state and transient load-detection algorithms" ENERGY AND BUILDINGS, LAUSANNE, CH, vol. 24, 1 janvier 1996 (1996-01-01), pages 51-64, XP002543035 ISSN: 0378-7788**
• **ROOS J G: "NON-INTRUSIVE LOAD MONITORING OF ELECTRICAL OF ELECTRICAL APPLIANCES" ELEKTRON, ELEKTRON VERLAG, AT, vol. 11, no. 4, 1 avril 1994 (1994-04-01), pages 27-30, XP009056124 ISSN: 0374-3098**
• **HART G W: "NONINTRUSIVE APPLIANCE LOAD MONITORING" PROCEEDINGS OF THE IEEE, IEEE. NEW YORK, US, vol. 80, no. 12, 1 décembre 1992 (1992-12-01), pages 1870-1891, XP000336363 ISSN: 0018-9219**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

EP 2 409 167 B1

## Description

La présente invention concerne de façon générale un procédé de filtrage de courbes de consommation d'énergie électrique, notamment en milieu résidentiel, afin de pouvoir être en mesure d'allouer la consommation électrique d'un site de consommation à telle ou telle classe d'appareils électriques. La finalité de la mise en oeuvre du procédé selon l'invention consiste à savoir allouer la consommation électrique d'un site à telle ou telle catégorie d'appareils, afin notamment de pouvoir suivre, et potentiellement réduire, la consommation de chaque catégorie d'appareils électriques.

Par conséquent, l'invention trouve en particulier son application dans le domaine de la maîtrise de la consommation d'énergie électrique par les particuliers et/ou les entreprises. En effet, la réduction de la consommation d'énergie électrique sur un site de consommation pourrait d'abord passer par une meilleure attribution de la consommation journalière aux différents appareils qui sont utilisés sur ce site.

## Etat de la Technique

On connaît déjà de multiples techniques pour suivre la consommation électrique d'un site, et pour allouer des parties de cette consommation électrique à tel ou tel appareil.

Selon l'une de ces techniques, chaque appareil électrique est pourvu d'un wattmètre qui relève la puissance électrique consommée. On peut ainsi déterminer la consommation électrique par appareil ou par groupe d'appareils. Cependant cette méthode possède un coût élevé aussi bien du fait du matériel supplémentaire employé que du fait de la nécessité d'installer et de paramétrer les appareils de mesure de la puissance consommée avec un plus grand niveau de détail que celui fourni de façon agrégée par le compteur électrique branché entre le réseau d'alimentation et le site de consommation.

Selon une autre technique, décrite dans le brevet EP 1 136 829 B1, on détecte la mise sous tension et la mise hors tension d'un appareil électrique, par l'intermédiaire d'un signal haute fréquence émis à la mise sous tension et à la coupure d'un appareil, ledit signal haute fréquence constituant une sorte de signature électrique de l'appareil en question. Ce sont les puissances instantanées qui sont enregistrées pour chaque appareil. Une base de données est créée : elle contient pour chaque appareil, différentes valeurs de puissances et différents signaux transitoires.

LESLIE K NORFORD ET AL: "Non-intrusive electrical load monitoring in commercial buildings based on steady-state and transient load-detection algorithms",ENERGY AND BUILDINGS, LAUSANNE, CH, (1996-01-01) décrit une technique non-intrusive d'analyse de la consommation électrique d'une pluralité d'appareils électriques fonctionnant sur un site de consommation, par filtrage d'une courbe de charge représentant la consommation électrique desdits appareils en fonction du temps.

La reconnaissance des appareils sur les courbes de charges puis le calcul de l'énergie qu'ils ont consommés se fait par rapprochement entre la base de données constituée et les courbes de charges enregistrées. Mais cela suppose que le propriétaire du site ou un technicien vienne effectuer l'apprentissage des appareils électriques, c'est-à-dire établisse un registre des appareils du site, et le tienne à jour en fonction des ajouts et/ou des déplacements d'appareils.

Les méthodes connues de détermination de la consommation d'appareils dans une installation électrique ont donc en commun un caractère intrusif vis-à-vis du site dont on veut analyser la consommation électrique. En effet, l'identification précise des appareils électriques présents chez un particulier est impossible sans utiliser des informations recueillies au préalable concernant les appareils présents sur le site. Cependant cette phase d'apprentissage induit une gêne chez l'usager et ne permet pas un changement des habitudes de consommation. En outre, plusieurs études de signatures des appareils électriques ont été effectuées depuis 1990, toutefois aucune n'a pu identifier les appareils électriques sans avoir recours à une forme quelconque d'intrusion, que ce soit lors d'une phase d'apprentissage manuelle, ou lors de la création d'une base de référence avec l'usager, ou lors de la surveillance ultérieure des achats ou branchements de matériel électriques effectués par l'usager.

Malgré la connaissance à priori, par des méthodes intrusives, du détail des installations électriques, les méthodes connues permettent au meilleur des cas de rendre compte d'environ 80 % de la consommation électrique en pointe, et souvent bien moins que 80 % en moyenne.

## Buts de l'invention

Un but général de l'invention est de proposer un procédé d'analyse de courbe de charge d'une installation électrique, et un dispositif mettant en oeuvre ledit procédé, qui soient à même de pallier aux inconvénients des procédés et systèmes connus dans l'état de la technique.

Un but particulier de l'invention est de proposer un procédé apte à extraire puis à séparer la consommation des appareils électriques fonctionnant dans une installation, sans aucune forme d'intrusion, simplement à partir de l'analyse et du traitement des courbes de charges journalières.

Un autre but de l'invention est de proposer un procédé d'analyse ou de filtrage d'une courbe de charge électrique, qui permettre d'allouer en moyenne plus de 85 % de la consommation électrique à des catégories bien identifiées d'appareils, et en tous cas plus de 70 % de la consommation à chaque instant, malgré l'absence de phase d'apprentissage manuelle des appareils électriques présents sur le site, ou l'absence d'une connaissance à priori des détails de l'installation électrique et des appareils qui y sont connectés.

Un autre but de l'invention est de proposer un procédé et un dispositif d'analyse de la consommation qui soit très économique et qui ne nécessite pas d'installation complémentaire, en dehors d'un simple boîtier pour l'acquisition de la courbe de charge à proximité du compteur électrique, et pour le traitement de ladite courbe de charge, soit localement sur le site, soit à distance de façon centralisée.

**Objet de l'invention**

Le principe de l'invention réside dans la capacité à extraire puis à séparer des appareils sans aucune forme d'intrusion, à partir de courbes de charges journalières globales. Afin d'arriver à cette extraction, il est nécessaire de définir, dans un premier temps, une classification innovante des appareils, à partir de cycles de consommation caractéristiques des appareils ou des types d'appareils.

Puis une phase automatique d'apprentissage permet de séparer et de créer une partition relative des appareils que l'usager a utilisés. Cette partition permet de récupérer des informations en puissance (active, réactive, apparente), en temps, en tension, en intensité, en impédance ou autres, permettant de reconstruire une grande majorité des cycles produits par un appareil en fonction. Cette phase de reconstruction est unique car elle repose sur un principe hiérarchique de choix de combinaisons de puissances possibles. On évalue des critères et des seuils spécifiques à chaque classe d'appareils, permettant de prendre en compte les spécificités en puissance des appareils.

Enfin, la méthode impose un ordre de présentation des algorithmes de filtrage de la courbe de charge, afin de réduire sensiblement les erreurs d'attribution de cycles.

Afin d'atteindre les buts visés, l'invention a plus précisément pour objet un procédé d'analyse de la consommation électrique d'une pluralité d'appareils électriques fonctionnant sur un site de consommation, par filtrage d'une courbe de charge représentant la consommation électrique desdits appareils en fonction du temps, caractérisé en ce qu'il comporte les étapes suivantes :

- préalablement au filtrage proprement dit de la courbe de charge :

  - enregistrer et numériser la courbe de charge, de façon à obtenir une courbe de charge numérisée par périodes de temps ;
  - définir un ensemble de classes d'appareils, chaque classe étant définie par des cycles similaires de variation de puissance en fonction du temps ;
  - définir pour chaque classe d'appareils, un algorithme de filtrage de la courbe de charge dédié à ladite classe d'appareils, ledit algorithme étant apte à extraire des cycles de variation de puissance de la courbe de charge numérisée, et à l'allouer à ladite classe d'appareils ;

- puis pendant le filtrage proprement dit de la courbe de charge numérisée, utiliser successivement les algorithmes de filtrage dédiés à chaque classe d'appareils, pour identifier et regrouper à partir de la courbe de charge numérisée, les cycles de variations de puissance consommée par les appareils électriques.

Selon un aspect de l'invention, l'étape de filtrage de la courbe de charge numérisée pour une classe d'appareils donnée, comporte les opérations suivantes :

- recherche et extraction à partir de la courbe de charge, des cycles de variation de puissance caractéristiques de la classe donnée d'appareils ;
- validation des cycles extraits en fonction de critères en puissance et en temps prédéfinis, et répartition des cycles extraits entre un ensemble de cycles valides correspondant au modèle de fonctionnement en puissance et en temps d'un appareil, et un ensemble de cycles provisoirement rejetés ;
- création d'une partition provisoire constituée de sous-ensembles incomplets de cycles valides de variation de puissance, chaque sous-ensemble incomplet comprenant des cycles d'un seul appareil;
- apprentissage local sur les cycles valides de chaque partition provisoire, de façon à définir des critères en puissance et en temps caractéristiques des cycles valides;
- à partir des critères en puissance et en temps issus de l'apprentissage local, reconstruction du modèle de fonctionnement chronologique complet ou quasi-complet de chaque appareil, en lui attribuant des cycles de variation de puissance auparavant provisoirement rejetés ;

- mise à jour de la classification et de l'apprentissage en fonction de l'étape de reconstruction, de façon à créer une partition définitive des cycles extraits, chaque partition correspondant à la consommation d'un appareil.

L'étape de recherche et d'extraction des cycles de variation de puissance caractéristiques d'une classe donnée d'appareils, consiste à définir des codes binaires caractéristiques correspondant aux variations de puissance de cette classe d'appareils, puis à soustraire de la courbe de charge numérisée, les codes binaires caractéristiques ainsi définis et à les classer soit dans un ensemble de cycles valides correspondant au modèle de fonctionnement d'un appareil, soit dans un ensemble de cycles provisoirement rejetés, puis à réinjecter les cycles provisoirement rejetés dans la courbe de charge avant la recherche des cycles de variation de puissance relatifs à une autre classe d'appareils.

Selon l'invention, pour valider les cycles extraits pour une classe donnée d'appareils, les caractéristiques en puissance et en temps des cycles extraits sont comparés aux critères en puissance et en temps prédéfinis pour cette classe, et ceux des cycles qui présentent des caractéristiques en puissance et en temps incompatibles avec les critères fixés sont provisoirement rejetés, les autres cycles sont définitivement validés comme appartenant à un appareil de la classe donnée.

La création d'une partition provisoire constituée de sous-ensembles incomplets de cycles de variation de puissance valides pour chaque appareil comporte des étapes consistant à regrouper les cycles de variation de puissance valides présentant sensiblement les mêmes valeurs des critères en puissance et en temps, de façon que chaque groupe de cycles représente les cycles d'un appareil de la classe ayant fonctionné sur la courbe de charge, puis à représenter la partition provisoire sous la forme d'une matrice d'informations où chaque ligne représente un appareil et chaque colonne contient les cycles extraits valides appartenant aux appareils.

L'étape d'apprentissage consiste à calculer les valeurs d'un ensemble de critères en puissance et en temps associés aux cycles valides de chaque appareil, puis à analyser statistiquement ces valeurs, et à stocker les statistiques obtenues en mémoire, sous la forme d'un vecteur d'informations associé à chaque appareil.

L'étape de reconstruction consiste à reconstituer pour chaque appareil, l'ensemble complet ou quasi-complet des cycles de variation de puissance émis par l'appareil entre son allumage et son extinction, en intégrant de façon chronologique dans l'ensemble des cycles valides de cet appareil, des cycles sélectionnés à partir de l'ensemble des cycles provisoirement rejetés, cette sélection se faisant à l'aide de critères et de seuils issus de l'apprentissage.

L'étape de création d'une partition définitive consiste à mettre à jour chaque sous-ensemble de cycles représentant un appareil de la classe filtrée, avec les cycles manquants tels que reconstruits lors de l'étape de reconstruction. On obtient à la fin de la mise à jour la part de consommation de la classe correspondant à cet appareil, et les variations de puissance non attribuées restantes sont réinjectées dans la courbe de charge restante.

De façon avantageuse, les critères en puissance et en temps sont auto-adaptatifs et varient d'une courbe de charge à une autre. Cela permet d'augmenter l'efficacité du procédé d'analyse des courbes de charges successives.

De préférence, le procédé selon l'invention comporte une étape consistant à agréger les consommations électriques de chaque classe d'appareils à partir de la partition définitive des cycles extraits, de façon à produire un état récapitulatif indiquant la consommation électrique, ou la proportion de consommation électrique, des appareils de chaque classe pendant une période d'analyse de la consommation.

Afin de disposer de suffisamment de données de variation de puissance, la courbe de charge est numérisée par périodes de temps inférieures ou égales à une seconde.

Dans un mode de réalisation avantageux en pratique, l'ensemble de classes prédéfinies d'appareils comporte au moins une des classes prises parmi les suivantes :

- la classe dite des pompes électriques ;
- la classe dite des résistances électriques ;
- la classe dite des fours à micro-ondes ;
- la classe dite des appareils électriques de gros électroménager ;
- la classe des autres appareils électriques ne rentrant pas dans une classe précédente.

La classe dite des pompes électriques est définie par un cycle de variation de puissance consommée comprenant successivement une première variation positive de puissance, une seconde variation négative de puissance, et une troisième variation négative de puissance.

La classe dite des appareils électriques de gros électroménager est définie par un cycle de variation de puissance consommée comprenant successivement au moins quatre variations de puissance, à savoir une première variation de puissance positive, une seconde variation de puissance négative, une troisième variation de puissance positive, et une quatrième variation de puissance négative.

La classe dite des fours à micro ondes est définie par quatre types de cycles distincts de variation de puissance, le premier type de cycle comportant une variation de puissance positive suivie d'une variation négative, le second type de cycle comportant deux variations positives suivies d'une variation négative, le troisième type de cycle comportant une variation positive suivie de deux variations négatives, et le quatrième type de cycle comportant deux successions constituées chacune d'une variation positive suivie d'une variation négative.

La classe dite des résistances électriques est définie par un cycle de variation de puissance consommée comprenant successivement une première variation positive de puissance suivie d'une seconde variation négative de puissance.

De préférence, la courbe de charge numérisée est filtrée successivement à l'aide d'un algorithme spécifique pour chaque classe d'appareils, et la succession desdits algorithmes est ordonnée. Ainsi, le procédé de filtrage met de préférence successivement en oeuvre l'algorithme de filtrage relatif à la classe des pompes, puis l'algorithme de filtrage relatif à la classe des fours à micro-onde, puis l'algorithme de filtrage relatif à la classe du gros électroménager, puis l'algorithme de filtrage relatif à la classe des résistances. Cet ordre permet de minimiser le nombre de cycles alloués à tort à un appareil, et par conséquent d'augmenter la performance du procédé de filtrage.

Le procédé selon l'invention peut être mis en oeuvre dans son intégralité sur le site de consommation, ou en partie sur le site de consommation et en partie sur un site de traitement distant. Ainsi, dans une variante de réalisation du procédé, l'étape d'acquisition de la courbe de charge est réalisée localement, et les valeurs numérisées représentatives de la courbe de charge sont alors traitées localement dans un boitier de traitement disposé sur le site de consommation.

Selon une autre variante du procédé, l'étape d'acquisition de la courbe de charge est réalisée localement, et les valeurs binaires représentatives de la courbe de charge sont ensuite transmises à un centre de traitement distant où sont effectuées les étapes de filtrage de la courbe de charge.

L'invention a également pour objet un dispositif de traitement destiné à être branché sur la ligne d'alimentation électrique d'un site de consommation, caractérisé en ce qu'il comporte un logiciel apte à mettre en oeuvre le procédé de filtrage selon l'invention.

L'invention sera mieux comprise en référence aux dessins, dans lesquels :

- la Figure 1 représente un schéma de principe des entrées et des sorties du procédé selon l'invention;
- la Figure 2 représente un extrait possible de courbe de charge que l'on peut enregistrer en temps réel et utiliser comme entrée du procédé.
- les Figures 3A à 3D représentent des signatures typiques d'appareils pour 4 classes extraites à partir des courbes de charges ;
- la Figure 4 représente un organigramme de principe de l'algorithme de filtrage global selon l'invention;
- la Figure 5.1 représente un organigramme plus détaillé de l'algorithme de filtrage de la courbe de charge et de construction des classes d'appareils ;
- la Figure 5.2 représente un organigramme de principe de l'algorithme de filtrage au niveau d'une classe d'appareils électriques;
- la Figure 5.3 représente un exemple d'organigramme pour la phase de reconstruction de cycles de consommation de l'organigramme de la figure 5.2 ;

## Description détaillée de l'invention

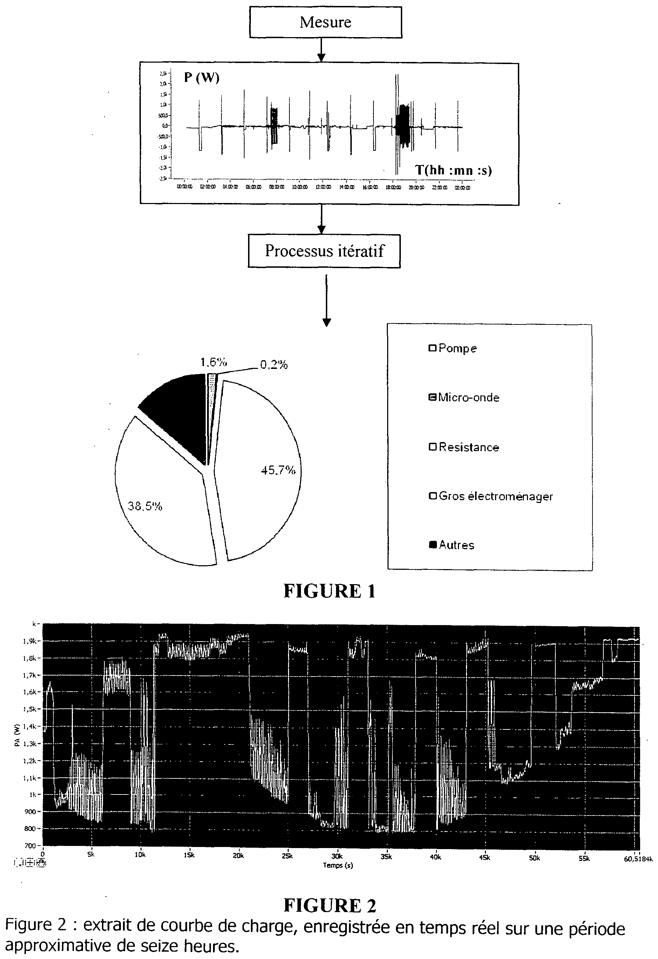

On se réfère à la figure 1. A un niveau global, il est possible de décrire le procédé selon l'invention en fonction des entrées qu'on doit lui fournir, et des sorties qu'il délivre.

En entrée du procédé, on dispose d'une mesure de la puissance électrique consommée sur un site de consommation. Cette mesure se traduit notamment, sous forme graphique, par une courbe de charge analogique représentant la puissance consommée, en fonction du temps, tel que représenté sur la figure 1 pendant une certaine période d'analyse.

La courbe de charge est soumise à un processus itératif, dont l'objectif est de répartir la consommation globale du site entre plusieurs catégories ou classes d'appareils, sans que l'on sache à priori quelle est la nature des appareils électriques en fonctionnement sur le site. La répartition de la consommation est alors présentée sous forme tabulaire, ou encore, comme représenté dans la figure 1, sous une forme graphique de secteurs donnant rapidement une indication visuelle de la consommation à attribuer à chaque classe d'appareils.

L'objectif à atteindre est d'obtenir un taux de 70% minimum de classification correcte des appareils, et un taux de classification supérieur à 85 % en moyenne. Comme on le verra plus loin, divers facteurs font qu'il n'est pas possible d'attribuer 100% d'une consommation électrique globale aux différents appareils, mais il faut arriver à un taux de classification significatif pour satisfaire à un certain niveau d'information pour l'usager qui rende le dispositif d'analyse suffisamment crédible.

**Système de mesure**

On utilise un système de mesure (non représenté) ayant la capacité d'enregistrer l'ensemble des variations électriques qui se produisent sur le réseau électrique d'un consommateur, sur une période de temps donnée avec un échantillonnage à la seconde. Ce système est muni de capteur d'intensité qui peut être matérialisé par des pinces ampéremetriques et un capteur de tension matérialisé par exemple par un transformateur (dont on connait la valeur) branché sur une prise du réseau. Ces variations sont représentées par un graphique nommé « courbe de charge.

En figure 2, on a représenté de manière plus détaillée un extrait d'une courbe de charge représentant la puissance active enregistrée sur une période de seize heures.

C'est à partir de telles courbes de charges que l'on va étudier le comportement en variations de puissance et en temps des appareils électriques. Pour analyser ces comportements, on a créé auparavant une base de référence contenant des courbes de charges dites « d'apprentissages ». Ces courbes contiennent l'activité d'appareils électriques couramment utilisés par les consommateurs comme l'aspirateur, le réfrigérateur, le micro-onde, la cafetière, le four, le fer à repasser, les lampes, les robots électroménagers, le grille-pain, les chauffages d'appoint, le chauffe-eau, le lave-linge, le lave-vaisselle, la télévision, etc.

La compréhension du fonctionnement des appareils électriques se base sur l'enregistrement de courbes de charges de puissance (active, réactive, apparente). Pour obtenir des courbes de charges enregistrées sur une certaine durée, il faut mesurer la puissance instantanée délivrée au réseau et enregistrer les grandeurs électriques élémentaires : la tension efficace du signal, *Ueff,* en volt (V), l'intensité efficace, *Ieff,* en ampères (A), et le facteur de puissance, *cos(φ).*

Le réseau électrique du particulier est alimenté par un courant alternatif de fréquence 50 Hz par exemple, et dont la tension est théoriquement de 220 V par exemple dans une série de pays. Bien entendu l'utilisation de fréquences et de tensions différentes ne change rien fondamentalement à la mesure de la puissance consommée.

Les appareils sont constitués en majorité par des récepteurs électromagnétiques (bobines, moteurs, etc.). La plupart des récepteurs ne sont pas purement résistifs mais ils ont un comportement soit inductif, soit capacitif. Cela implique un déphasage entre le courant et la tension. Il est donc nécessaire de prendre en compte le facteur de puissance (*cos(φ)*) déterminé par l'angle de déphasage *φ* entre la tension nominale et le courant nominal.

A partir de ces grandeurs, on détermine d'autres variables électriques. Ainsi, comme cela est bien connu, on calcule deux types de puissances utiles pour un courant alternatif :

- la puissance active, notée *P,* exprimée en watts (W), qui correspond à une fourniture d'énergie transmise au récepteur et convertible en chaleur ou en travail. La puissance active est celle qui est le plus généralement utilisée car elle correspond à la réalité du travail ou de la chaleur fournie par la charge en tenant compte du déphasage entre la tension et le courant. On a :

$$P = U_{eff}.I_{eff}\cos(\varphi)$$

- la puissance réactive, Q, en volt.ampères.réactif (VAR) qui correspond à la puissance fictive qui caractérise l'échange d'énergie non utilisée pour fournir un travail. On a :

$$Q = U_{eff}.I_{eff}\sin(\varphi)$$

Enfin, on calcule l'impédance électrique, Z, en Ohm ($\Omega$), qui mesure l'opposition d'un circuit électrique au passage d'un courant alternatif sinusoïdal. On a :

$$Z = \frac{U}{I}$$

**Définition de classes d'appareils en fonction de leur mode de consommation typique**

Un aspect mis en évidence par l'expérimentation, et sur lequel se base l'invention, est que l'analyse systématique de multiples courbes de charge pour des appareils réels d'une base de référence donne des renseignements très utiles sur le profil de consommation de chaque appareil.

Cette analyse permet alors de créer une classification appropriée de plusieurs appareils standards.

En effet, l'étude des courbes de charge de la base de référence a montré qu'il est possible de regrouper certains appareils électriques selon des classes. Ces classes sont définies suivant un mode de fonctionnement provoqué par les composants internes des appareils. Beaucoup d'appareils électriques ont un comportement en puissance similaire malgré une utilité très différente (exemple : le réfrigérateur et l'aspirateur).

Les appareils électriques sont construits avec différents composants électriques et produisent donc différents comportements caractéristiques. Quand on analyse la variation de puissance active sur une courbe de charge, entre l'allumage et l'extinction d'un appareil, on observe la répétition de « cycles » ordonnés de variations de puissance active. Un cycle de puissance se définit par la succession de variations positives et négatives de puissance active. A partir de ce constat, il a été possible de définir quatre classes d'appareils électriques que l'on retrouve communément dans le secteur résidentiel. Ces classes sont caractérisées par un ou plusieurs cycles de puissance typiques.

Bien entendu, l'invention ne se limite pas à la classification de la consommation d'appareils électriques domestiques, mais peut aisément être étendue par l'homme du métier, à d'autres types d'appareils électriques, notamment en milieu industriel, qui donneront sans doute lieu à des classifications complémentaires.

A partir de cette première étude de fonctionnement d'appareils, on définira les termes suivants qui seront employés dans la suite :

*Cycle de puissance* : succession ordonnée de variations de puissance positive ou négative intervenant à des intervalles de temps réguliers.

*Modèle de fonctionnement*: succession régulière de cycles de puissance produits par l'appareil entre sa mise sous tension et sa mise hors tension sur le réseau électrique.

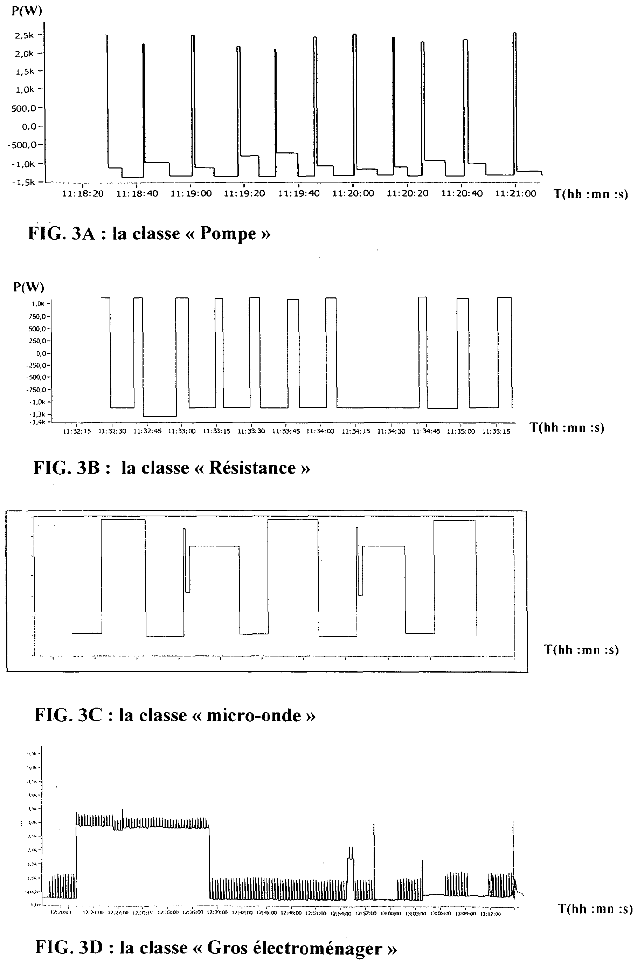

On va maintenant décrire plus en détail, en relation avec la figure 3, les quatre classes d'appareils utilisées dans le cadre de la présente description.

La figure 3A représente une courbe de charge typique des appareils de la classe des pompes. La classe « Pompe » caractérise les appareils ayant un fonctionnement de type compressif. Lorsque l'appareil fonctionne, il produit un cycle régulier défini par une variation positive de puissance (notée $\Delta P_1 > 0$) et deux variations négatives de puissance (notées $\Delta P_2 < 0$, $\Delta P_3 < 0$). Dans cette classe, on trouve des appareils comme le réfrigérateur, l'aspirateur, tous types de pompes, etc.

La figure 3B représente une courbe de charge typique des résistances électriques. La classe « Résistance » caractérise les appareils munis d'une résistance ou d'un moteur universel. Ces appareils génèrent un cycle de puissance défini par une variation positive de puissance (notée $\Delta P_1 > 0$) suivi d'une variation négative de puissance ($\Delta P_2 < 0$). Dans cette classe, on peut trouver en milieu résidentiel des appareils tels que le four, la cafetière, la bouilloire, les convecteurs, le chauffe-eau, les ampoules, etc.

La figure 3C représente une courbe de charge typique des fours à micro-ondes. Le four à micro-ondes est un appareil que l'on classe seul dans une classe dite « Micro-onde » car son comportement en puissance se définit par quatre cycles de puissance distincts qui permettent de le séparer des autres appareils.

Le premier type de cycle de puissance est composé de deux variations de puissance :

- une première variation de puissance positive : $\Delta P_1 > 0$,
- une deuxième variation de puissance négative : $\Delta P_2 < 0$.

Un four à micro-ondes peut générer des cycles correspondant au modèle de cycle de la classe « Résistance », c'est-à-dire deux variations de puissance. Toutefois, les intervalles de temps entre les différents cycles ne sont pas aussi réguliers que dans le cas des cycles générés par des appareils résistifs. Ce type de cycle constitue la première catégorie de variations que le four à micro-ondes génère.

Le deuxième type de cycle pour la classe « Micro-onde » est composé de trois variations de puissance :

- une première variation de puissance positive : $\Delta P_1 > 0$
- une deuxième variation de puissance positive : $\Delta P_2 < 0$
- une troisième variation de puissance négative : $\Delta P_3 < 0$

Le troisième type de cycle pour la classe « Micro-onde » est composé de trois variations de puissance :

- une première variation de puissance positive : $\Delta P_1 > 0$
- une deuxième variation de puissance négative : $\Delta P_2 > 0$
- une troisième variation de puissance négative : $\Delta P_3 < 0$

Comme on le constate, il s'agit d'un cycle correspondant au modèle de cycle de la classe « Pompe ». Toutefois, les intervalles de temps entre les variations de puissance ne sont pas comparables à ceux générés par les appareils compressifs.

Le quatrième cycle pour la classe « Micro-onde » est composé de quatre variations successives de puissance :

- une première variation de puissance positive : $\Delta P_1 > 0$
- une deuxième variation de puissance négative : $\Delta P_2 < 0$
- une troisième variation de puissance positive : $\Delta P_3 > 0$
- une quatrième variation de puissance négative : $\Delta P_4 < 0$

Le four à micro-onde est le seul appareil électrique à être défini par quatre cycles de puissance possibles. On a pu constater que lorsqu'il fonctionne, le micro-onde ne va pas produire uniquement un seul des quatre cycles possibles. Plusieurs types de cycles peuvent alterner en quelques minutes. C'est aussi cette alternance de cycles de puissance, différents dans le temps, qui permet de discriminer cet appareil par rapport aux appareils des autres classes.

Enfin, on regroupe au sein de la classe « Gros Electroménager », les appareils tels que : le lave-linge, le lave-vaisselle, le sèche-linge.

Ils sont facilement identifiables sur une courbe de charge comme celle représentée en figure 3D, car ce sont des appareils qui génèrent un très grand nombre de cycles et dont le fonctionnement s'étale généralement sur une très grande durée (de 30 minutes au minimum à 2h30 en moyenne). Le cycle de puissance généré par ce type d'appareil est dans la majorité des cas composé de quatre variations successives de puissance. Toutefois, certains appareils de ce type peuvent avoir des cycles composés de plus de quatre variations de puissance. Lors des expérimentations, il a été possible de dénombrer jusqu'à dix variations successives. Il s'agit toujours d'un nombre pair de variations et l'intervalle entre les différentes variations est de l'ordre de la seconde. Les variations de puissance qui composent les cycles sont donc :

- une première variation positive : $\Delta P_1 > 0$
- une deuxième variation négative : $\Delta P_2 < 0$
- une troisième variation positive : $\Delta P_3 > 0$
- une quatrième variation négative : $\Delta P_4 < 0$
- etc.

La majorité des appareils électriques à usage domestique se classe parmi les quatre grandes classes définies ci-dessus. Au sein d'une même classe, les caractéristiques en temps et en puissance de ces cycles diffèrent cependant suivant l'appareil qui fonctionne.

Toutefois, il existe quelques appareils dont le fonctionnement en puissance n'est pas facile à définir et qui n'appartiendront pas à ces quatre classes. De ce fait, on rajoutera à la classification, une classe dite «*Autres appareils*» qui rendra compte de toutes les variations de puissance non attribuées, étant entendu que l'objectif est de minimiser la fraction de la consommation totale qui relève de cette classe.

**Principe du procédé global de filtrage des courbes de charge**

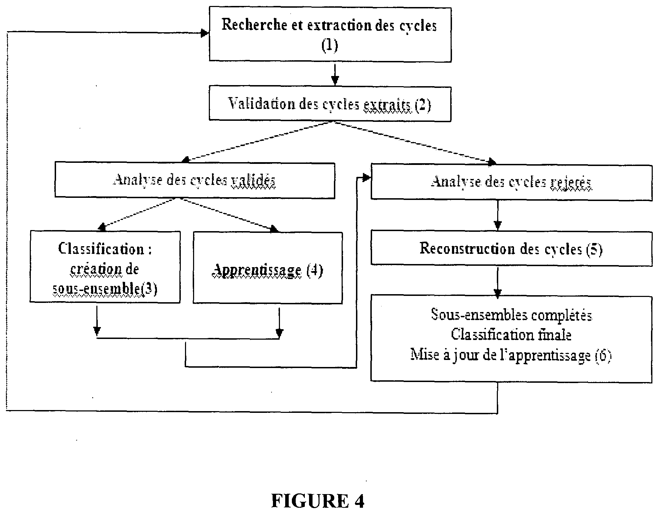

La courbe de charge étant supposée obtenue par la mesure, et les classes d'appareils étant définies par leurs cycles de puissance, on va maintenant décrire dans sa globalité le traitement qui est appliqué à la courbe de charge, en se référant à la figure 4.

On part du principe que la courbe de charge analogique P = f(t) est d'abord codée sous forme numérique, par exemple en associant, par convention, à chaque variation positive de puissance la valeur « 1 », et en associant à chaque variation négative de puissance, la valeur « 0 ». Bien entendu, d'autres codifications seraient possibles, sans affecter la généralité de l'invention.

Le processus global de filtrage de la courbe de charge fonctionne avec une série d'étapes principales référencées 1 à 6 sur la figure 4, qui seront décrites en détail plus loin, et qui sont communes à toutes les classes. Cependant la répartition des appareils entre les classes est importante car chaque classe est filtrée avec un algorithme spécifique.

Pour chaque classe, on filtre la courbe de charge pour en extraire la consommation des appareils correspondant à ladite classe. L'extraction repose sur la recherche de cycles de variation de puissance caractéristiques ayant permis de définir la classe.

Ainsi, à titre d'exemple, pour rechercher dans la courbe de charge les cycles de variation de puissance créés par les appareils de type pompe, on identifie dans la courbe de charge numérisée, tous les codes « 100 », et on les soustrait de la courbe de charge. A la fin de cette étape d'extraction, l'algorithme sépare les cycles qui se distinguent aisément de ceux qui sont problématiques et qui ont besoin d'un second niveau d'analyse pour pouvoir être affectés à une classe d'appareils.

En effet, un cycle « 100 » peut avoir été généré effectivement par un appareil de la classe « Pompes », ou par d'autres appareils différents, mais dont la superposition des cycles de variation de puissance donne aussi un code « 100 ». Afin de discriminer les vrais cycles « 100 » dus aux pompes, on associe à la caractérisation de la classe des pompes par le code « 100 », une caractérisation supplémentaire sur la base de critères de puissance liés aux variations de puissance, et de critères de temps d'apparition de ces variations de puissance dans le cycle. Ces critères de puissance et de temps sont fixés à l'avance sur la base de l'analyse préalable d'une multitude d'appareils, et ces critères fixés en puissance et en temps sont des invariants pour chaque classe d'appareils.

Par exemple, dans le cas des réfrigérateurs usuels, qui relèvent de la classe des pompes, on a constaté que la première variation de puissance $\Delta P_1$ oscille dans un intervalle de l'ordre de 100 watts autour de la variation de puissance moyenne $\Delta P_1$ de l'ensemble des réfrigérateurs domestiques sur le marché.

Par conséquent, on peut dire que la détection d'un code « 100 » correspondant à une première variation de puissance située en-dehors de l'intervalle ci-dessus, permettrait de conclure que l'appareil en question n'est pas un réfrigérateur, et par conséquent de rejeter le code « 100 » correspondant, comme étant invalide.

Il en découle que l'étape d'extraction des cycles permet aussi de former une première partition d'appareils au sein de la classe analysée. Chaque appareil d'une classe est défini par un sous-ensemble de cycles contenant un certain nombre de cycles qu'il aura produit entre son allumage et son extinction.

A partir de ces cycles et pour chaque sous-ensemble, l'algorithme de la classe réalise un apprentissage. Il s'agit d'une synthèse d'informations statistiques concernant la consommation des appareils, et ces informations statistiques sont alors regroupées dans des vecteurs d'information, comme expliqué plus en détail plus loin.

La récupération de ces informations statistiques représente le coeur du fonctionnement de l'algorithme car elle est l'unique moyen de définir et de séparer par la suite les appareils entre eux au sein d'une même classe.

En effet, les sous-ensembles de cycles sont très rarement complets, c'est-à-dire que l'algorithme a d'abord rejeté un certain nombre de cycles produits par les appareils de la classe car ils ce correspondaient pas, dans un premier temps, aux critères de puissance et de temps fixés pour la classe. Ce rejet intervient notamment dans le cas où plusieurs appareils ont fonctionné ensemble et dont les cycles de puissance se sont mélangés.

L'intégration et la reconstruction de l'ensemble des cycles générés par un appareil, entre son allumage et son extinction, se fait par conséquent par une phase dite de reconstruction. Cette phase récupère les données issues de l'apprentissage et reconstruit les cycles manquants de variation de puissance pour chaque sous-ensemble de la partition. Après la phase de reconstruction, il est possible de calculer la puissance consommée par chaque appareil, et pas conséquent la consommation de l'ensemble des appareils de cette classe.

On procède de la même manière pour les autres classes, et pour la consommation restante de la courbe de charge, qui correspond à la catégorie «Autres », c'est-à-dire l'ensemble de la consommation qui n'a pas pu être allouée à l'une des classes d'appareils prédéfinies.

A partir de la consommation de chaque classe d'appareils, il est aisé de calculer le pourcentage de cette consommation par rapport à la consommation d'ensemble correspondant à la courbe de charge pendant la période d'analyse. Bien entendu, la consommation respective des différentes classes d'appareils et de la classe « Autres » peut alors être simplement représentée sous forme tabulaire ou sous forme graphique (voir figure 1) pour le client en charge du site de consommation.

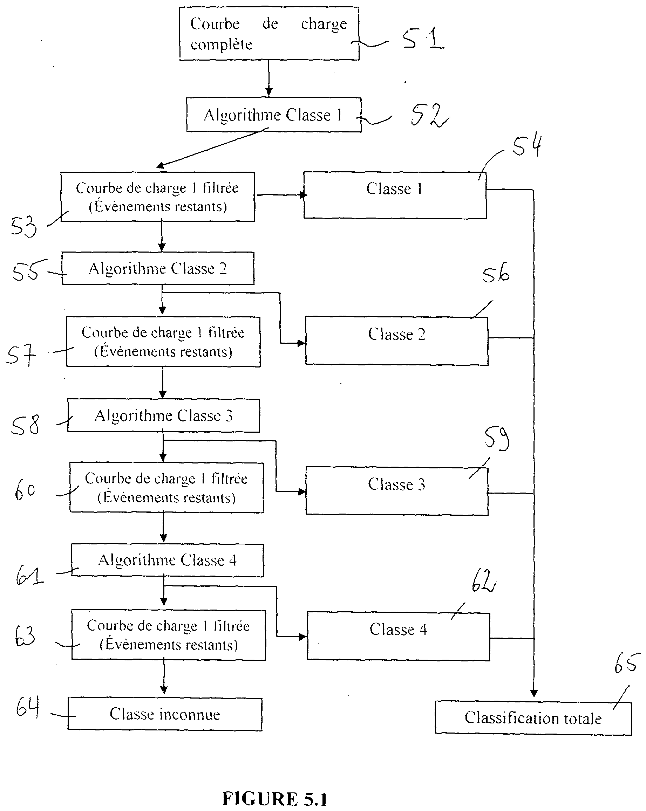

**Filtrage global de la courbe de charge (Figure 5.1)**

Le procédé de filtrage global décrit de façon générale plus haut a été illustré plus en détail dans la figure 5.1, qui montre bien les principales étapes de ce procédé global de filtrage de la courbe de charge :

La première étape, notée 51, consiste à charger et à lire la courbe de charge complète tel qu'enregistrée et codifiée en une succession de « 1 » et de « 0 ».

Puis, dans une seconde étape, notée 52, on applique le premier algorithme de filtrage, correspondant à la classe 1, à l'ensemble de la courbe de charge. Dans la mesure où le premier algorithme correspond à celui de la classe des pompes, cela reviendra à rechercher l'ensemble des codes « 100 » dans la courbe de charge complète, à les extraire par soustraction de la courbe de charge, et à les ranger dans une première classe notée classe 1.

A la fin du filtrage de la courbe de charge par le premier algorithme, on applique en 55 l'algorithme 2 à la courbe de charge résiduelle 53 déjà filtrée par l'algorithme 1, c'est-à-dire la courbe de charge moins les cycles correspondant à la classe 1. Le filtrage par l'algorithme 2 donne lieu à la recherche dans la courbe de charge résiduelle, des codes numériques correspondant à la deuxième classe d'appareils. Ces codes sont rangés en 56 dans la classe 2, et on obtient en 57 une nouvelle courbe de charge résiduelle, de laquelle ont été soustraits tous les codes correspondant aux variations de puissance des appareils de la seconde classe.

Puis de façon similaire, on applique le même procédé (étapes 58 à 63) aux codes des classes restantes, à savoir les classes 3 et 4 dans l'hypothèse où la classification se fait sur quatre classes d'appareils.

A la fin de ce processus itératif, on obtient en 65 une classification aussi totale que possible à ce stade, c'est-à-dire que tous les codes correspondant aux différentes classes ont été extraits de la courbe de charge, et que les codes restants dans la courbe de charge correspondent à une classe inconnue ou « autres », notée 64, qui correspond soit à des cycles de variations de puissances d'appareils ne rentrant pas dans les classes prédéfinies, soit des cycles d'appareils des classes 1 à 4, mais qui n'ont pas encore pu être reconnus comme tels à ce stade, et qui nécessiteront un traitement complémentaire.

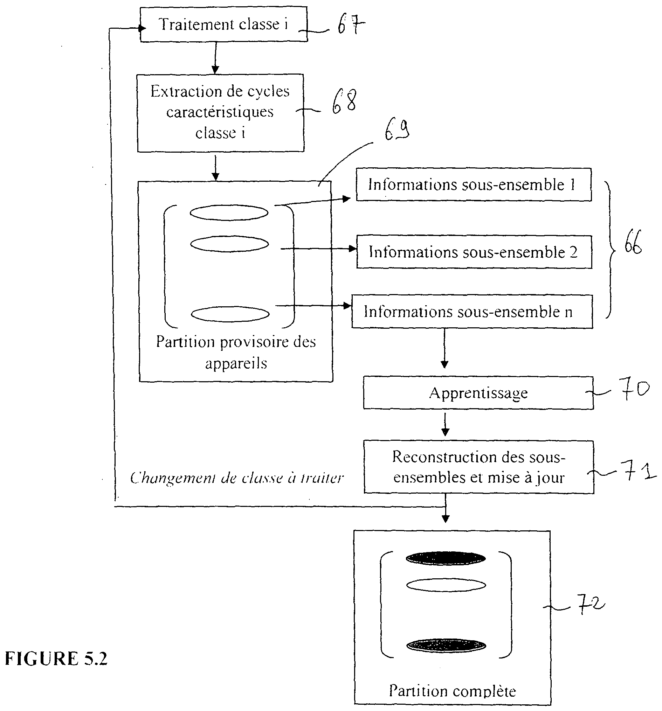

**Description des algorithmes de filtrage local pour chaque classe d'appareils (figure 5.2)**

Chaque algorithme spécifique à une classe d'appareils doit réaliser les fonctions suivantes:

- extraire de la courbe de charge les cycles de variation de puissance de la classe concernée, sur la base de la reconnaissance d'un code caractéristique de la classe en question, comme décrit plus haut ;
- analyser la validité des cycles extraits de la courbe de charge : en effet ; il est possible que certains cycles extraits correspondent en fait à la superposition de cycles de variation de puissance de plusieurs appareils. Ces cycles doivent être identifiés comme invalides et réinjectés dans la courbe de charge pour la suite du traitement ;
- séparer les cycles de variation de puissance de deux appareils qui fonctionnent en même temps ;
- reconstruire chronologiquement un modèle de fonctionnement complet de chaque appareil ;
- effectuer une partition des appareils dans une même classe.

La figure 5.2 représente de façon plus détaillée l'organigramme de l'algorithme de filtrage de la courbe de charge pour chaque classe d'appareils. Cet organigramme comporte les étapes principales suivantes, dont chacune sera décrite plus en détail plus loin :

- en 68, recherche et extraction des cycles de variation de puissance d'une classe donnée, notée la classe $i$ ;
- validation (non représentés sur cette figure) des cycles extraits, de façon à s'assurer que les cycles extraits correspondent bien à la classe i en question ;
- en 69, création à l'intérieur de cette classe $i$, d'une première classification constituée de sous-ensembles de cycles appartenant à un même appareil, ce qui conduit à une partition provisoire des appareils ;
- en 70, apprentissage local sur les cycles correspondant à chaque appareil, à partir d'informations en puissance et en temps (66) concernant les cycles, pour affiner les critères en puissance et en temps de la classe donnée;
- sur la base de cet apprentissage, reconstruction en 71 des cycles manquants, pour compléter le modèle de fonctionnement chronologique de chaque appareil;
- mise à jour de la classification et de l'apprentissage, et création en 72 d'une partition définitive d'appareils dans la classe donnée $i$.

Chacune de ces étapes va maintenant être décrite plus en détail.

**Etape 1 (Figure 4): recherche et extraction des cycles.**

Le tableau ci-dessous résume les cycles de puissance de chaque classe et son code binaire associé sur la base duquel on recherche les cycles.

*Tableau: code binaire associé aux cycles de puissance pour chaque classe*

| Classe | Cycles | Code binaire associé |
|---|---|---|
| Pompe | $\Delta P_1>0, \Delta P_2<0, \Delta P_3<0$ | 100 |
| Résistance | $\Delta P_1>0, \Delta P_2<0$ | 10 |
| Micro-onde | $\Delta P_1>0, \Delta P_2<0$ | 10 |
| | $\Delta P_1>0, \Delta P_2>0, \Delta P_3<0$ | 110 |
| | $\Delta P_1>0, \Delta P_2<0, \Delta P_3<0$ | 100 |
| | $\Delta P_1>0, \Delta P_2<0, \Delta P_3>0, \Delta P_4<0$ | 1010 |

(suite)

| Classe | Cycles | Code binaire associé |
|---|---|---|
| Gros électroménager | $\Delta P_1 > 0$, $\Delta P_2 < 0$, ..., $\Delta P_{i-1} > 0$, $\Delta P_i < 0$ <br> $i$ allant de $1$ à $K$ (pair) | 1010,...,0 |

L'algorithme parcourt la courbe de charge codée sous forme binaire pour filtrer les cycles correspondant à la classe $i$ étudiée. Pour filtrer ces cycles, on définit des codes binaires à rechercher dans la courbe de charge. Un cycle est composé de plusieurs variations de puissance, définies par le code suivant :

$$\begin{cases} 1 & \text{si } \Delta P_i > 0 \\ 0 & \text{sinon} \end{cases}$$

Une courbe de charge se traduit par des variations de puissance regroupées dans un tableau noté $CC$. On obtient donc, pour la courbe de charge, un tableau contenant par exemple les valeurs binaires suivantes :

$$CC = \{1,0,0,1,0,1,0, ... ... ... ,0\}$$

L'algorithme de la classe $i$ recherche et extrait du tableau $CC$ le ou les codes correspondant à la classe $i$, comme résumés dans le tableau ci-dessus.

L'expérimentation a permis de constater, de façon surprenante, que pour optimiser le processus de filtrage de la courbe de charge et éviter une grande majorité des erreurs d'attribution dans les classes, il vaut mieux imposer un ordre préférentiel pour les filtrages correspondant aux différentes classes, c'est-à-dire filtrer les cycles des classes de manière ordonnée.

L'ordre de présentation idéal recherché doit permettre de filtrer plus aisément :

- des cycles faciles à extraire de la courbe de charge car très réguliers (c'est le cas des appareils de type « pompes »),
- des cycles produits sur une durée très courte (micro-onde).

En définitive, on constate que le meilleur ordre de mise en oeuvre des algorithmes pour filtrer une courbe de charge se révèle être :

(1) L'algorithme des « Pompes ».
(2) L'algorithme du « Micro-onde ».
(3) L'algorithme du « Gros Electroménager ».
(4) L'algorithme des « Résistances ».

**Etape 2 (Figure 4): validation des cycles extraits.**

A la fin de la procédure d'extraction des codes binaires, l'algorithme analyse les cycles pour les valider ou les rejeter en se basant sur un critère invariant de la classe. Les critères invariants utilisés sont des critères de puissance et de temps associés aux cycles. Les caractéristiques en puissance et en temps des cycles sont donc comparées aux critères en puissance et en temps prédéfinis.

En effet, les variations de puissance observées pour un cycle ont des valeurs qui peuvent être comparées à des valeurs attendues pour une classe d'appareils ou pour un appareil. La validation d'un cycle s'effectue alors avec un critère défini comme une combinaison de puissances associée à l'ensemble des variations de puissance des cycles, notamment la valeur de la première variation de puissance du cycle.

En outre, entre les différentes variations de puissance d'un cycle, il s'écoule un certain temps noté $\Delta T$, et ce temps peut également être comparé à des critères de temps prédéfinis pour chaque classe d'appareils.

Ainsi, une première analyse est effectuée sur les cycles extraits de la courbe de charge pour valider dans un premier temps que ces cycles correspondent bien à des appareils de la classe concernée, et pour rejeter les cycles incompatibles avec les critères fixés de puissance ou de temps, sur lesquels l'algorithme ne peut par conséquent pas faire de choix précis.

En conséquence, un cycle valide pour un appareil est un cycle qui présente la bonne succession de variations de puissance (c'est-à-dire le bon code), et les caractéristiques en puissance et en temps attendues pour cet appareil.

La plupart du temps, les rejets de cycles sont dus à deux appareils ayant fonctionné en même temps, et dont les cycles se sont mélangés, de sorte qu'il convient de les analyser plus en détail.

En fonction de cette analyse sur la base de critères fixés, deux ensembles sont alors créés :

- celui des cycles validés, noté *ECv* ;
- celui des cycles rejetés provisoirement, noté *ECr* ;

Au cours de l'exécution des quatre algorithmes de filtrage correspondant aux quatre classes d'appareils, on a donc dans un premier temps quatre ensembles ECv de cycles valides mais incomplets. En effet, il manque des cycles dans le fonctionnement de chaque appareil à cause des cycles rejetés provisoirement. Chaque ensemble ECv est alors complété par une mise à jour à la fin d'un algorithme de filtrage, avant de passer à l'algorithme suivant.

### Etape 3 (Figure 4): création de la première classification provisoire des appareils

Une première analyse statistique des variations de puissance composant les cycles validés permet de créer une partition des cycles attribués à une classe d'appareils, où chaque sous-ensemble représente les cycles d'un appareil de la classe ayant fonctionné sur la courbe de charge.

Cette classification des cycles va ensuite permettre d'effectuer, comme expliqué plus loin, un apprentissage sur les cycles, et un dénombrement du nombre d'appareils appartenant à la classe, puis d'ébaucher le modèle de fonctionnement complet de chaque appareil.

Les résultats sont donnés sous la forme d'une matrice d'informations où chaque ligne représente un appareil (ou sous-ensemble noté $SS_i$) et chaque colonne contient les cycles extraits valides appartenant aux appareils.

### Etape 4 (Figure 4): apprentissage local des cycles

Après les étapes de recherche, de validation et de classification des cycles, l'étape 4 représente la seconde partie de fonctionnement de l'algorithme, et constitue une étape fondamentale de la classification des appareils. Les informations obtenues à la fin de cette étape permettent à l'algorithme d'évaluer les variations de puissance à prendre en compte pour reconstruire le modèle de fonctionnement complet d'un appareil électrique.

Dans la mesure où des cycles ont été provisoirement rejetés pour un appareil, il n'est pas encore possible de déterminer la consommation électrique pour cet appareil. Par l'étape 4 d'apprentissage suivie de l'étape 5 de reconstruction des cycles, il s'agit d'affiner la consommation de chaque appareil dans sa classe. Pour cela, il est nécessaire de récupérer les cycles de variation de puissance qui manquent dans le modèle de fonctionnement de cet appareil.

Avant de pouvoir récupérer les cycles manquants, il est nécessaire de définir de nouvelles valeurs de critères de fonctionnement, plus proches du fonctionnement réel des appareils, en remplacement des valeurs des critères préalablement fixés en puissance et en temps qui ont permis de construire les ensembles ECv et ECr.

Afin de définir de nouveaux critères et les valeurs correspondantes, on analyse statistiquement les différentes caractéristiques en puissance et en temps des cycles observés.

Les tableaux ci-dessous donnent un exemple des différents critères qui peuvent être calculés et analysés statistiquement pour chaque algorithme correspondant aux quatre classes envisagées.

*Tableau 1: liste des critères à analyser pour les pompes et résistances*

| Critère | Pompes | Résistances |
|---|---|---|
| variation de puissance | $\Delta P_1 = P_1 - 0$<br>$\Delta P_2 = P_1 - P_2$<br>$\Delta P_3 = P_3 - P_2$<br><br>$$\Delta P_T = \sum_{i=1}^{3} P_i$$ | $\Delta P_1 = P_1 - 0$<br>$\Delta P_2 = P_1 - P_2$ |
| variation de temps | $\Delta T_1 = T(P_2) - T(P_1)$<br>$\Delta T_2 = T(P_3) - T(P_2)$<br>$\Delta T_3 = T(P_3) - T(P_1)$<br>$\Delta T_4 = T(P_1) - T(P'_1)$ | $\Delta T_1 = T(P_2) - T(P_1)$<br>$\Delta T_4 = T(P_1) - T(P'_1)$ |

*Tableau 2 : liste des critères à analyser pour les classes micro-onde et gros électroménager*

| Critère | Micro-onde | Gros Electroménager |
|---|---|---|
| variation de puissance | $\Delta P_1 = P_1 - 0$<br>$\Delta P_2 = P_1 - P_2$<br>$\Delta P_3 = P_3 - P_2$<br>$\Delta P_4 = P_4 - P_3$<br><br>$$\Delta P_T = \sum_{i=1}^{3} P_i$$ | $\Delta P_k = P_{k+1} - P_k$<br><br>$$\Delta P_T = \sum_{i=1}^{k} P_i$$ |
| variation de temps | $\Delta T_1 = T(P_2) - T(P_1)$<br>$\Delta T_2 = T(P_3) - T(P_2)$<br>$\Delta T_3 = T(P_3) - T(P_1)$<br>$\Delta T_4 = T(P_1) - T(P'_1)$<br>$\Delta T_5 = T(P_4) - T(P_3)$ | $\Delta T_k = T(P_{k+1}) - T(P_k)$<br>$\Delta T_4 = T(P_1) - T(P'_1)$<br>Durée phase de chauffe<br>Durée phase de tambour<br>Durée essorage |

Pour chaque critère en puissance et en temps défini dans chaque classe, l'algorithme va analyser les cycles avec les outils statistiques suivants : moyenne, médiane, variance, maximum, minimum.

Les résultats de ces calculs sont stockés en mémoire, pour chaque sous-ensemble de cycles correspondant à un appareil, dans un vecteur que l'on nomme « vecteur d'informations », et noté $VI_{i=1,...,F}$, avec F représentant la dimension de la partition. Ces vecteurs sont la seule source d'information que l'algorithme possède sur les appareils issus de la courbe de charge, et remplacent toute acquisition manuelle d'information sur les appareils, par exemple par le propriétaire du site de consommation ou un technicien. En ce sens, le procédé est bien non intrusif.

Les étapes 5 et 6 suivantes du procédé de filtrage font partie de la troisième phase de l'algorithme qui traite du problème de l'analyse des cycles provisoirement rejetés et de la phase de « reconstruction » du modèle de fonctionnement de chaque appareil. C'est cette dernière phase qui va donner la classification finale des appareils appartenant à la classe étudiée.

**Etape 5 (Figure 4): reconstruction de l'ensemble complet de cycles pour chaque appareil**

Il s'agit de retrouver les cycles manquants pour un appareil donné, pour pouvoir, à la fin de l'étape de reconstruction des cycles, calculer la consommation totale de cet appareil pendant la période d'analyse. Cet appareil correspond à une ligne de la matrice ECv des cycles valides.

Dans l'étape de reconstruction, l'algorithme du procédé selon l'invention parcourt l'ensemble des cycles rejetés ECr pour chaque appareil, afin de rechercher les variations de puissance correspondantes aux cycles qui ont été rejetés dans un premier temps, mais qui appartiennent bien à un sous-ensemble de la partition, compte tenu des valeurs des critères issus de l'étape d'apprentissage.

Compte tenu des différents critères en puissance et en temps issus de l'apprentissage, pour chaque classe il y a une phase de reconstruction définie avec ses propres critères et ses propres seuils. La phase de reconstruction s'applique de façon itérative à tous les sous-ensembles (donc appareils) créés avec l'apprentissage.

Chaque algorithme d'une classe base sa phase de reconstruction sur le principe d'une méthode d'aide à la décision multicritères, notamment de type AHP, acronyme pour « Analytic Hierarchy Process » en terminologie anglo-saxonne. Ce genre de méthode est connu par l'homme de métier en ne sera pas décrite en détail.

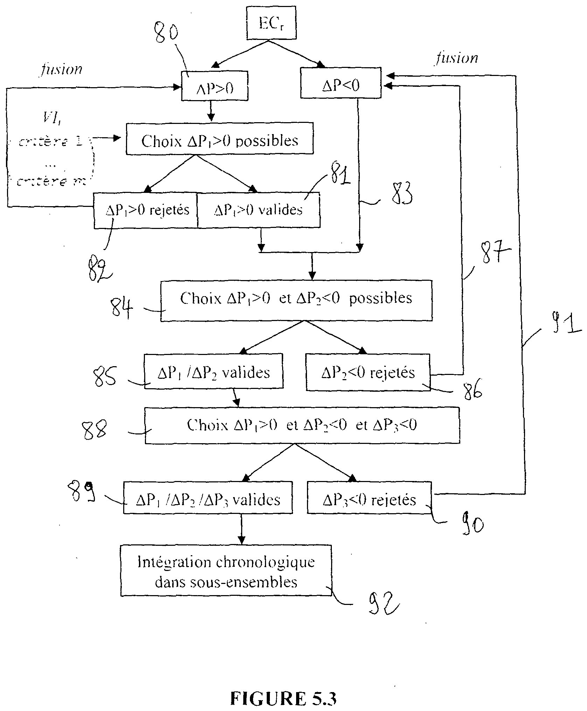

On a représenté simplement à titre d'exemple en figure 5.3, l'organigramme d'un algorithme de reconstruction utilisant la méthode AHP, appliqué à l'exemple de la classe « Pompe ».

Comme on l'a vu, la classe « Pompe » possède des cycles de variations de puissances caractérisés par trois variations de puissance : $\Delta P1 > 0$, $\Delta P2 < 0$ et $\Delta P3 < 0$.

On extrait en 80 à partir de l'ensemble des cycles provisoirement rejetés pour la classe « Pompes », ceux qui ont une première variation de puissance $\Delta P1$ positive. Parmi ces cycles, on retient en 81 l'ensemble des cycles dont les valeurs du vecteur d'informations correspondent aux valeurs des critères en puissance et en temps issus de l'apprentissage. Les autres cycles sont à nouveau réinjectés, en 82, dans ECr.

Puis on extrait de l'ensemble ECr des cycles provisoirement rejetés, en 83, ceux qui ont une seconde variation de puissance négative, et on les combine en 84 aux cycles déjà extraits sur la base de leur première variation de puissance $\Delta P1$ valide. On forme ainsi en 85 un ensemble de cycles dont les premières et secondes variations de puissance $\Delta P1$, $\Delta P2$ sont compatibles avec les valeurs issues de l'apprentissage. Les cycles 86 dont la seconde variation de puissance ne convient pas, sont réinjectés en 87 dans ECr.

En 88, 89, 90, 91, On itère ce procédé pour les troisièmes variations de puissance $\Delta P3$, de façon à obtenir en 92 uniquement les cycles pour lesquels les variations $\Delta P1$, $\Delta P2$ et $\Delta P3$ sont cohérents avec les valeurs des critères issues de l'apprentissage. Ces cycles préalablement rejetés à titre provisoire, sont alors réintégrés de façon chronologique dans le sous-ensemble provisoire des cycles de cet appareil, de façon à former un sous-ensemble de cycles reconstruit ou définitif pour cet appareil.

On procède de même pour l'ensemble des appareils d'une classe, puis pour toutes les classes. Ce faisant, on vide au fur et à mesure l'ensemble Ecr des cycles provisoirement rejetés. A la fin du traitement pour une classe, il ne reste que quelques cycles résiduels pour cette classe, qui n'ont pas trouvé d'affectation dans le modèle de fonctionnement d'un appareil de cette classe. Ces cycles résiduels sont alors réinjectés dans l'ensemble global des cycles provisoirement rejetés, afin de prendre part au traitement de reconstruction pour une autre classe, et ainsi de suite.

A la fin du traitement de reconstruction pour la dernière classe d'appareils, il ne reste dans l'ensemble des cycles rejetés, que des cycles de variation de puissance qui n'ont pas pu être affectés à aucun appareil d'aucune classe. Ces cycles sont alors affectés à la classe de consommation « Autres ».

Il est à noter que l'ensemble des cycles validés définitivement pour tous les appareils d'une classe, correspondent à la consommation totale identifiée pour cette classe d'appareils, ce qui permet de calculer et de représenter la part de consommation de cette classe dans la courbe de charge globale.

### Etape 6 (Figure 4): classification finale et mises à jour

L'algorithme met à jour pour chaque classe d'appareils, chaque sous-ensemble de cycles avec les cycles manquants qui ont été reconstruits. La classe est complétée avec la mise à jour des cycles manquants et la taille de l'ensemble ECr est réduite. A la fin du processus total de filtrage, on doit obtenir une classe « Autres » la plus petite possible. A partir de cette classification définitive, l'algorithme met également à jour les vecteurs d'information stockés en mémoire.

En définitive, l'ensemble des étapes des algorithmes de filtrage a pour but de produire une classification fiable des appareils appartenant à une même classe et de minimiser la taille de la classe « Autres», c'est-à-dire le nombre d'évènements de puissance non attribués à une classe d'appareils ou à un appareil.

### Définition des critères en puissance et en temps, et de leurs seuils

Pour chaque sous-ensemble de la classification réalisée dans la première partie de l'algorithme (filtrage de la courbe de charge), les critères en puissance et en temps prennent des valeurs que l'on appelle « seuils ». La définition ou le calcul de ces seuils permet à l'algorithme d'effectuer un choix par rapport à une variation de puissance appartenant à l'ensemble des cycles rejetés.

Comme on l'a vu, les seuils sont de différentes natures : il y a des seuils fixés, et des seuils auto-adaptés lors de l'exécution de l'algorithme.

### Les seuils fixés :

Ces seuils sont fixés en fonction de l'expérience acquise grâce à l'étude d'une base de référence d'appareils et de leur consommation en fonctionnement. Ces seuils fixés sont des invariants de la classe étudiée. Ils vont être appliqués à certains critères de la classe, et ils resteront inchangés quel que soit le sous-ensemble de cycles étudié. Ces seuils se présentent sous la forme d'un intervalle de valeurs. La définition d'un intervalle de valeurs possibles permet à l'algorithme une certaine souplesse dans l'analyse des caractéristiques d'une variation de puissance, de façon à éviter un choix arbitraire pouvant entrainer des erreurs de classification.

### Les seuils auto-adaptés :

Ce sont des seuils que l'on calcule lors de la phase d'apprentissage, à l'aide d'outils statistiques simples appliqués à certains critères de la classe. Ils sont donc caractéristiques du sous-ensemble de cycles étudiés.

Dans le cas de la classe « Pompe », les seuils auto-adaptés sont par exemple :

- la moyenne des variations de puissance de la première variation de puissance du cycle, notée *mean* ($\Delta P_1$) ;

- la moyenne des variations de puissance de la deuxième variation de puissance du cycle, notée *mean* ($\Delta P_2$) ;
- la moyenne du délai entre la première et la seconde variation de puissance notée *mean* ($\Delta T_1$)

C'est dans la phase de reconstruction des cycles que l'on utilise la majorité des seuils, sous la forme de combinaisons entre les seuils fixés et les seuils auto-adaptés. Ces combinaisons permettent de prendre en compte pour chaque variation de puissance analysée, les caractéristiques du sous-ensemble de cycles, mais aussi les caractéristiques générales de la classe étudiée.

Le tableau ci-dessous donne à titre d'exemple la nature, les valeurs des seuils, et les critères utilisés dans l'algorithme des « Pompes ». Bien entendu les critères et les seuils correspondants sont variables en fonction de chaque classe d'appareils et peuvent aisément être déterminés par l'homme de métier.

*Tableau 3: critères et seuils associés à l'algorithme « Pompe ».*

|  | Critère | Nature du seuil | Valeur du seuil |
|---|---|---|---|
| (1) | $\Delta P_T = \sum_{i=1}^{3} P_i$ | fixé | [-40w,40w] |
| (2) | ($\Delta P_1$)<br>($\Delta P_2$)<br>($\Delta P_3$)<br>($\Delta T_3$) | fixé et auto-adapté | [*mean*($\Delta P_1$) - 200W,*mean*($\Delta P_1$) + 200W]<br>[*mean*($\Delta P_2$) - 250W,*mean*($\Delta P_2$) + 200W]<br>[*mean*($\Delta P_3$) - 50W,*mean*($\Delta P_3$) + 50W]<br>[*mean*($\Delta T_3$) - 5min,*mean*($\Delta T_2$) + 10min] |
| (3) | ($\Delta P_1$) | fixé et auto-adapté | [*mean*($\Delta P_1$) - 700W,*mean*($\Delta P_1$) + 700W] |
| (4) | ($\Delta P_2$)<br>($\Delta P_1$) | fixé et auto-adapté | [*mean*($\Delta P_2$) - 250W,*mean*($\Delta P_2$) + 200W]<br>[*mean*($\Delta T_1$) - 1s,*mean*($\Delta T_1$) + 1s] |
| (5) | ($\Delta P_3$)<br>($\Delta T_3$) | fixé et auto-adapté | [*mean*($\Delta P_3$) - 100W,*mean*($\Delta P_3$) + 100W]<br>[*mean*($\Delta T_3$) - 5min,*mean*($\Delta T_3$) + 15min] |
| (6)<br><br>($\Delta T_4$) Nombre de cycles | $\sum_{i=1}^{3} P_i$ | fixé et auto-adapté | [-40w,40w]<br>[*mean*($\Delta T_4$) - 10min,*mean*($\Delta T_4$) + 10min]<br><br>Nombre de cycles > 5 |

La fonction des seuils auto adaptés est de permettre à l'algorithme de s'adapter à la courbe de charge et aux vrais appareils qui sont en présence. En conséquence, il n'existe pas de règle de décision rigide mais plutôt des intervalles de valeurs permettant une souplesse dans le choix des variations de puissance.

La définition des critères et des seuils associés, pour chaque algorithme, rend le processus de filtrage à la fois cohérent et particulier, car le principe de filtrage reste le même pour chaque classe, mais chaque algorithme possède certaines caractéristiques propres du fait des seuils auto-adaptés.

C'est cette dualité qui permet d'aboutir à une classification des appareils sans informations extérieures au système, seulement à partir des courbes de charges.

A chaque courbe de charge, les fichiers d'apprentissage sont plus complets dans les informations analysées, et permettent d'affiner les seuils des critères.

**Avantages de l'invention**

L'invention remédie au problème posé et atteint les buts visés. Grâce à la définition de classes d'appareils électriques en fonction de leurs caractéristiques de consommation (cycles de variation de puissance consommée en fonction du temps), l'invention a montré qu'il est possible de créer un processus itératif capable d'extraire des signatures de puissance et de temps pour chaque classe d'appareils, et de répartir les appareils du site dans plusieurs classes prédéfinies, simplement par filtrage de la courbe de charge globale, sans aucune autre information préalable sur les appareils, à condition simplement de disposer préalablement d'un ensemble de classes définies à partir d'une base de référence d'appareils électriques.

Si l'analyse des cycles de puissance de la courbe de charge ne permet pas encore d'identifier avec précision un appareil donné dans une classe d'appareils, elle permet néanmoins d'attribuer chaque appareil du site de consommation à l'une des classes prédéfinies, ce qui permet de répartir la consommation globale entre les classes d'appareils présentes sur le site. Cela permet en particulier de détecter des classes d'appareils qui consomment le plus, et par conséquent de prendre des mesures correctives sur le site, afin notamment de réduire la consommation d'une classe d'appareils, et/ou la consommation globale du site.

L'expérience a montré que, à la différence des procédés existants, le procédé selon l'invention permet d'obtenir un taux d'attribution de la consommation à une classe d'appareils, supérieur à 85 % en moyenne, et supérieur à 70 % quels que soient les cas de figure.

Il est encore important de noter que la mise en oeuvre du procédé et du dispositif selon l'invention à un caractère totalement non intrusif vis-à-vis de l'utilisateur du site, ce qui est un gage de son efficacité et de la prise en compte de la répartition de consommation effectuée.

La mise en oeuvre du procédé selon l'invention nécessite simplement la mise en oeuvre d'un simple boitier électronique disposé au niveau du compteur électrique du site, et pourvu d'un logiciel permettant d'acquérir la courbe de charge et de la filtrer comme décrit plus haut, étant entendu que le traitement lui-même peut être effectué localement sur le site, ou encore à distance de façon centralisée.

## Revendications

1. Procédé d'analyse de la consommation électrique d'une pluralité d'appareils électriques fonctionnant sur un site de consommation, par filtrage d'une courbe de charge représentant la consommation électrique desdits appareils en fonction du temps, comportant les étapes suivantes :

- préalablement au filtrage proprement dit de la courbe de charge :

  - enregistrer et numériser la courbe de charge, de façon à obtenir une courbe de charge numérisée par périodes de temps ;
  - définir un ensemble de classes d'appareils, chaque classe étant définie par des cycles similaires de variation de puissance ;
  - définir pour chaque classe d'appareils, un algorithme de filtrage de la courbe de charge dédié à ladite classe d'appareils, ledit algorithme étant apte à extraire des cycles de variation de puissance de la courbe de charge numérisée, et à l'allouer à ladite classe d'appareils ;

- pendant le filtrage de la courbe de charge numérisée :

  - utiliser successivement les algorithmes de filtrage dédiés à chaque classe d'appareils, pour identifier et regrouper à partir de la courbe de charge numérisée, les cycles de variations de puissance consommée par les appareils électriques ;
  le procédé étant caractérisé d'une part en ce que la courbe de charge numérisée est filtrée successivement à l'aide d'un algorithme spécifique pour chaque classe d'appareils, selon une succession ordonnée d'algorithmes de filtrage, et le procédé étant caractérisé d'autre part en ce que l'étape de filtrage proprement dite de la courbe de charge numérisée pour une classe d'appareils donnée comporte les opérations suivantes :

    - recherche et extraction à partir de la courbe de charge, des cycles de variation de puissance caractéristiques de la classe donnée d'appareils ;
    - validation des cycles extraits en fonction de critères en puissance et en temps prédéfinis, et répartition des cycles extraits entre un ensemble de cycles valides correspondant au modèle de fonctionnement en puissance et en temps d'un appareil, et un ensemble de cycles provisoirement rejetés ;
    - création d'une partition provisoire constituée de sous-ensembles incomplets de cycles valides, chaque sous-ensemble incomplet comprenant des cycles d'un seul appareil ;
    - apprentissage local des cycles valides de chaque partition provisoire, de façon à définir des critères caractéristiques des cycles valides ;
    - à partir des critères issus de l'apprentissage local, reconstruction du modèle de fonctionnement chronologique complet ou quasi-complet de chaque appareil, en lui attribuant des cycles de variation de puissance auparavant provisoirement rejetés ;
    - mise à jour de la classification et de l'apprentissage en fonction de l'étape de reconstruction, de façon à créer une partition définitive des cycles extraits, chaque partition correspondant à la consommation d'un appareil.

**2.** Procédé selon la revendication 1, **caractérisé en ce que** l'étape de recherche et d'extraction des cycles de variation de puissance caractéristiques d'une classe donnée d'appareils, consiste à définir des codes binaires caractéristiques correspondant aux variations de puissance de cette classe d'appareils, puis à soustraire de la courbe de charge numérisée, les codes binaires caractéristiques ainsi définis et à les classer soit dans un ensemble de cycles valides correspondant au modèle de fonctionnement d'un appareil, soit dans un ensemble de cycles provisoirement rejetés, puis à réinjecter les cycles provisoirement rejetés dans la courbe de charge avant la recherche des cycles de variation de puissance relatifs à une autre classe d'appareils.

**3.** Procédé selon la revendication 1, **caractérisé en ce que** pour valider les cycles extraits pour une classe donnée d'appareils, les caractéristiques en puissance et en temps des cycles extraits sont comparés aux critères en puissance et en temps prédéfinis pour cette classe, et ceux des cycles qui présentent des caractéristiques en puissance et en temps incompatibles avec les critères fixés sont provisoirement rejetés, les autres cycles sont définitivement validés comme appartenant à un appareil de la classe donnée.

**4.** Procédé selon la revendication 1, **caractérisé en ce que** la création d'une partition provisoire constituée de sous-ensembles incomplets de cycles de variation de puissance valides pour chaque appareil comporte des étapes consistant à regrouper les cycles de variation de puissance valides présentant sensiblement les mêmes valeurs des critères en puissance et en temps, de façon que chaque groupe de cycles représente les cycles d'un appareil de la classe ayant fonctionné sur la courbe de charge, puis à représenter la partition provisoire sous la forme d'une matrice d'informations où chaque ligne représente un appareil et chaque colonne contient les cycles extraits valides appartenant aux appareils.

**5.** Procédé selon la revendication 1, **caractérisé en ce que** l'étape d'apprentissage consiste à calculer les valeurs d'un ensemble de critères en puissance et en temps associés aux cycles valides de chaque appareil, puis à analyser statistiquement ces valeurs, et à stocker les statistiques obtenues en mémoire, sous la forme d'un vecteur d'informations associé à chaque appareil.

**6.** Procédé selon la revendication 1, **caractérisé en ce que** l'étape de reconstruction consiste, à reconstituer pour chaque appareil, l'ensemble complet ou quasi-complet des cycles de variation de puissance pour cet appareil entre son allumage et son extinction, en intégrant de façon chronologique dans l'ensemble des cycles valides de cet appareil, des cycles sélectionnés à partir de l'ensemble des cycles provisoirement rejetés, cette sélection se faisant à l'aide de critères et de seuils issus de l'apprentissage.

**7.** Procédé selon la revendication 1, **caractérisé en ce que** l'étape de création d'une partition définitive consiste à mettre à jour chaque sous-ensemble de cycles représentant un appareil de la classe filtrée, avec les cycles manquants tels que reconstruits lors de l'étape de reconstruction.

**8.** Procédé selon l'une quelconque des revendications 1 à 7, **caractérisé en ce que** les critères en puissance et en temps sont auto-adaptatifs et varient d'une courbe de charge à une autre.

**9.** Procédé selon la revendication 1, **caractérisé en ce qu'**il comporte une étape consistant à agréger les consommations électriques de chaque classe d'appareils à partir de la partition définitive des cycles extraits, de façon à produire un état récapitulatif indiquant la consommation électrique, ou la proportion de consommation électrique, des appareils de chaque classe pendant une période d'analyse de la consommation.

**10.** Procédé selon la revendication 1, **caractérisé en ce que** la courbe de charge est numérisée par périodes de temps inférieures ou égales à une seconde.

**11.** Procédé selon l'une des revendications précédentes, **caractérisé en ce que** l'ensemble de classes prédéfinies d'appareils comporte au moins une des classes prises parmi les suivantes :

- la classe dite des pompes électriques ;
- la classe dite des résistances électriques ;
- la classe dite des fours à micro-ondes ;
- la classe dite des appareils électriques de gros électroménager ;
- la classe des autres appareils électriques ne rentrant pas dans une classe précédente.

**12.** Procédé selon la revendication 11, **caractérisé en ce que** la classe dite des pompes électriques est définie par un cycle de variation de puissance consommée comprenant successivement une première variation positive de puissance, une seconde variation négative de puissance, et une troisième variation négative de puissance.

**13.** Procédé selon la revendication 11, **caractérisé en ce que** la classe dite des appareils électriques de gros électroménager est définie par un cycle de variation de puissance consommée comprenant successivement au moins quatre variations de puissance, à savoir une première variation de puissance positive, une seconde variation de puissance négative, une troisième variation de puissance positive, et une quatrième variation de puissance négative.

**14.** Procédé selon la revendication 11, **caractérisé en ce que** la classe dite des fours à micro ondes est définie par quatre types de cycles distincts de variation de puissance, le premier type de cycle comportant une variation de puissance positive suivie d'une variation négative, le second type de cycle comportant deux variations positives suivies d'une variation négative, le troisième type de cycle comportant une variation positive suivie de deux variations négatives, et le quatrième type de cycle comportant deux successions constituées chacune d'une variation positive suivie d'une variation négative.

**15.** Procédé selon la revendication 11, **caractérisé en ce que** la classe dite des résistances électriques est définie par un cycle de variation de puissance consommée comprenant successivement une première variation positive de puissance suivie d'une seconde variation négative de puissance.

**16.** Procédé selon la revendication 15, **caractérisé en ce qu'**il met en oeuvre successivement l'algorithme de filtrage relatif à la classe des pompes, puis l'algorithme de filtrage relatif à la classe des fours à micro-onde, puis l'algorithme de filtrage relatif à la classe du gros électroménager, puis l'algorithme de filtrage relatif à la classe des résistances.

**17.** Procédé selon l'une quelconque des revendications précédentes, **caractérisé en ce que** les étapes d'acquisition de la courbe de charge et de filtrage de la courbe de charge sont réalisées localement sur le site de consommation.

**18.** Procédé selon l'une quelconque des revendications 1 à 17, **caractérisé en ce que** l'étape d'acquisition de la courbe de charge est réalisée localement, et **en ce que** des valeurs binaires représentatives de la courbe de charge sont ensuite transmises à un centre de traitement distant où sont effectuées les étapes de filtrage de la courbe de charge.

**19.** Dispositif de traitement destiné à être branché sur la ligne d'alimentation électrique d'un site de consommation, **caractérisé en ce qu'**il comporte un logiciel adapté à mettre en oeuvre le procédé selon l'une quelconque des revendications précédentes.

**Patentansprüche**

**1.** Analyseverfahren des Stromverbrauchs einer Vielzahl von an einem Verbrauchsstandort funktionierenden elektronischen Geräten per Filterung einer Lastkurve, die den Stromverbrauch der genannten Geräte in Abhängigkeit von der Zeit darstellt, umfassend die folgenden Stufen:

- vor der Filterung im eigentlichen Sinne der Lastkurve:

- Abspeichern und Digitalisieren der Lastkurve derart, dass eine per Zeitperioden digitalisierte Lastkurve erhalten wird;
- Definieren einer Gruppe von Geräteklassen, wobei jede Klasse durch ähnliche Zyklen von Leistungsvariationen definiert ist;
- Definieren eines Filteralgorithmus der jeder der genannten Geräteklasse dedizierten Lastkurve für jede Geräteklasse, wobei der genannte Algorithmus geeignet ist, Zyklen der Leistungsvariation der digitalisierten Lastkurve zu extrahieren und der genannten Geräteklasse zuzuordnen;

- während der Filterung der digitalisierten Lastkurve:

- sukzessives Verwenden der jeder Geräteklasse dedizierten Filteralgorithmen, um ab der digitalisierten Lastkurve die Zyklen der Variation der von den elektrischen Geräten verbrauchten Leistung zu identifizieren und zusammenzufassen;
wobei das Verfahren einerseits **dadurch gekennzeichnet ist, dass** die digitalisierte Lastkurve mithilfe eines spezifischen Algorithmus für jede Geräteklasse gemäß einer geordneten Folge von Filterungsalgorithmen sukzessive gefiltert ist und das Verfahren andererseits **dadurch gekennzeichnet ist, dass** die Filterungsstufe im eigentlichen Sinne der digitalisierten Lastkurve für eine bestimmte Geräteklasse die folgenden Operationen umfasst:

- Suche und Extraktion ab der Lastkurve der Zyklen der charakteristischen Leistungsvariation der bestimmten Geräteklasse;
- Validierung der in Abhängigkeit von den Leistungskriterien und den vordefinierten Zeiten extrahierten Zyklen und Verteilung der extrahierten Zyklen in einer Gruppe von gültigen Zyklen, die dem Betriebsmodell in Leistung und in Zeit eines Geräts entsprechen, und einer Gruppe von vorläufig abgelehnten Zyklen;
- Anlegen einer vorläufigen Unterteilung, die aus unvollständigen Teilgruppen von gültigen Zyklen gebildet ist, wobei jede unvollständige Teilgruppe Zyklen eines einzigen Geräts umfasst;
- lokales Lernen der gültigen Zyklen jeder vorläufigen Unterteilung derart, dass charakteristische Kriterien der gültigen Zyklen definiert werden;
- ausgehend von den aus dem lokalen Lernen stammenden Kriterien Wiederaufbau des kompletten oder quasi-kompletten chronologischen Funktionsmodells jedes Geräts durch Zuteilen dazu der zuvor vorläufig abgelehnten Zyklen der Leistungsvariation;
- Aktualisieren der Klassifizierung und des Lernens in Abhängigkeit von der Wiederaufbaustufe derart, dass eine endgültige Unterteilung der extrahierten Zyklen angelegt wird, wobei jede Unterteilung dem Verbrauch eines Geräts entspricht.

2. Verfahren gemäß Anspruch 1, **dadurch gekennzeichnet, dass** die Such- und Extraktionsstufe der für eine bestimmte Geräteklasse charakteristischen Zyklen der Leistungsvariation in der Definition der charakteristischen binären Codes, die den Leistungsvariationen dieser Geräteklasse entsprechen, dann in der Subtraktion der auf diese Weise definierten charakteristischen binären Codes aus der digitalisierten Lastkurve und deren Klassifizierung entweder in eine Gruppe von gültigen Zyklen, die dem Funktionsmodell eines Geräts entsprechen, oder in eine Gruppe von vorläufig abgelehnten Zyklen, dann dem erneuten Zuführen der vorläufig abgelehnten Zyklen in die Lastkurve vor der Suche der zu einer anderen Geräteklasse relativen Zyklen der Leistungsvariation besteht.

3. Verfahren gemäß Anspruch 1, **dadurch gekennzeichnet, dass** die Leistungs- und Zeitmerkmale der extrahierten Zyklen zum Validieren der extrahierten Zyklen für eine bestimmte Geräteklasse mit den für diese Klasse vordefinierten Leistungs- und Zeitkriterien verglichen werden, und die Zyklen, die mit den festgelegten Kriterien inkompatible Leistungs- und Zeitmerkmale aufweisen, vorläufig abgelehnt werden, die anderen Kriterien endgültig als zu einem Gerät der bestimmten Klasse zugehörig validiert werden.

4. Verfahren gemäß Anspruch 1, **dadurch gekennzeichnet, dass** das Anlegen einer vorläufigen Unterteilung, die aus unvollständigen Teilgruppen von für jedes Gerät gültigen Zyklen der Leistungsvariation gebildet ist, Stufen umfasst, die in der Zusammenfassung der gültigen Zyklen der Leistungsvariation bestehen, die deutlich dieselben Werte der Leistungs- und Zeitkriterien derart aufweisen, dass jede Gruppe von Zyklen die Zyklen eines Geräts der Klasse aufweist, die auf der Leistungskurve funktioniert hat, dann in der Darstellung der vorläufigen Unterteilung in Form einer Informationsmatrix, in der jede Zeile ein Gerät und jede Spalte die gültigen extrahierten Zyklen, die zu den Geräten gehören, darstellt.

5. Verfahren gemäß Anspruch 1, **dadurch gekennzeichnet, dass** die Lernstufe in der Berechnung der Werte einer Gruppe von Leistungs- und Zeitkriterien, die den gültigen Zyklen jedes Geräts zugeordnet sind, dann in der statistischen Analyse dieser Werte und in der Speicherung der erhaltenen Statistiken im Speicher in Form eines jedem Gerät zugeordneten Informationsvektors besteht.

6. Verfahren gemäß Anspruch 1, **dadurch gekennzeichnet, dass** die Wiederaufbaustufe im Wiederaufbau der kompletten oder quasi-kompletten Gruppe der Zyklen der Leistungsvariation für dieses Gerät zwischen seinem Einschalten und seinem Ausschalten durch chronologische Integration in die Gruppe der gültigen Zyklen dieses Geräts, der aus der Gruppe der vorläufig abgelehnten Zyklen ausgewählten Zyklen für jedes Gerät besteht, wobei diese Auswahl mithilfe von aus dem Lernen stammenden Kriterien und Schwellenwerten erfolgt.

7. Verfahren gemäß Anspruch 1, **dadurch gekennzeichnet, dass** die Stufe des Anlegens einer endgültigen Unterteilung in der Aktualisierung jeder Teilgruppe von ein Gerät der gefilterten Klasse darstellenden Zyklen mit fehlenden Zyklen besteht, wie sie z. B. in der Wiederaufbaustufe wiederaufgebaut wurden.

8.  Verfahren gemäß irgendeinem der Ansprüche 1 bis 7, **dadurch gekennzeichnet, dass** die Leistungs- und Zeitkriterien autoadaptiv sind und von einer Lastkurve zur anderen variieren.

9.  Verfahren gemäß Anspruch 1, **dadurch gekennzeichnet, dass** es eine Stufe umfasst, die in der Zusammenfassung des jeweiligen Stromverbrauchs jeder Geräteklasse ab der endgültigen Unterteilung der extrahierten Zyklen derart besteht, dass eine zusammenfassende Aufstellung erzeugt wird, die den Stromverbrauch oder den Anteil des Stromverbrauchs der Geräte jeder Klasse während eines Analysezeitraums des Verbrauchs angibt.

10. Verfahren gemäß Anspruch 1, **dadurch gekennzeichnet, dass** die Lastkurve nach Zeitperioden kleiner als oder gleich einer Sekunde digitalisiert ist.

11. Verfahren gemäß einem der voranstehenden Ansprüche, **dadurch gekennzeichnet, dass** die Gruppe der vordefinierten Geräteklassen wenigstens eine der aus den folgenden ausgewählten Klassen umfasst:

    - die als elektrische Pumpen bezeichnet Klasse;
    - die als elektrische Widerstände bezeichnete Klasse;
    - die als Mikrowellenöfen bezeichnete Klasse;
    - die als elektrische Geräte großer Elektrohaushaltsgeräte bezeichnete Klasse;
    - die Klasse der anderen elektrischen Geräte, die nicht zu einer der voranstehenden Klassen gehören.

12. Verfahren gemäß Anspruch 11, **dadurch gekennzeichnet, dass** die als elektrische Pumpen bezeichnete Klasse durch einen Zyklus der verbrauchten Leistungsvariation definiert ist, der sukzessive eine erste positive Leistungsvariation, eine zweite negative Leistungsvariation und eine dritte negative Leistungsvariation umfasst.

13. Verfahren gemäß Anspruch 11, **dadurch gekennzeichnet, dass** die als elektrische Geräte großer Elektrohaushaltsgeräte bezeichnete Klasse durch einen Zyklus der verbrauchten Leistungsvariation definiert ist, die sukzessive wenigstens vier Leistungsvariationen umfasst, und zwar eine erste positive Leistungsvariation, eine zweite negative Leistungsvariation, eine dritte positive Leistungsvariation und eine vierte negative Leistungsvariation.

14. Verfahren gemäß Anspruch 11, **dadurch gekennzeichnet, dass** die als Mikrowellenöfen bezeichnete Klasse durch vier unterschiedliche Typen von Leistungsvariationen definiert ist, wobei der erste Zyklustyp eine positive Leistungsvariation gefolgt von einer negativen Variation umfasst, der zweite Zyklustyp zwei positive Variationen gefolgt von einer negativen Variation umfasst, der dritte Zyklustyp eine positive Variation gefolgt von zwei negativen Variationen umfasst und der vierte Zyklustyp zwei Folgen umfasst, die jeweils aus einer positiven Variation gefolgt von einer negativen Variation gebildet ist.

15. Verfahren gemäß Anspruch 11, **dadurch gekennzeichnet, dass** die als elektrische Widerstände bezeichnete Klasse durch einen Zyklus der verbrauchten Leistungsvariation definiert ist, der sukzessive eine erste positive Leistungsvariation gefolgt von einer zweiten negativen Leistungsvariation umfasst.

16. Verfahren gemäß Anspruch 15, **dadurch gekennzeichnet, dass** es sukzessive den Filterungsalgorithmus relativ zur Klasse der Pumpen, dann den Filterungsalgorithmus relativ zur Klasse der Mikrowellenöfen, dann den Filterungsalgorithmus relativ zur Klasse der großen Elektrohaushaltsgeräte relativ zur Klasse der Widerstände umsetzt.

17. Verfahren gemäß irgendeinem der voranstehenden Ansprüche, **dadurch gekennzeichnet, dass** die Erwerbsstufen der Lastkurve und der Filterung der Lastkurve lokal an dem Verbrauchsstandort realisiert sind.

18. Verfahren gemäß irgendeinem der Ansprüche 1 bis 17, **dadurch gekennzeichnet, dass** die Erwerbsstufe der Lastkurve lokal realisiert ist und dass die die Lastkurve darstellenden binären Werte anschließend auf ein entferntes Verarbeitungszentrum übertragen werden, wo die Filterungsstufen der Lastkurve durchgeführt werden.

19. Verarbeitungsvorrichtung, die dazu bestimmt ist, an eine Stromversorgungsleitung eines Verbrauchsstandortes angeschlossen zu sein, **dadurch gekennzeichnet, dass** sie eine Software umfasst, die geeignet ist, das Verfahren gemäß irgendeinem der voranstehenden Ansprüche umzusetzen.

**Claims**

1. Method for analysing the electrical consumption of a plurality of electrical appliances operating on a consumption site, by filtering a demand curve representing the electrical consumption of said appliances according to time, comprising the following steps:

- - before the filtering per se of the demand curve:

  ○ - recording and digitising the demand curve, in such a way as to obtain a demand curve digitalised by periods of time;
  ○ - defining a set of categories of appliances, with each category being defined by similar cycles of power variation;
  ○ - defining for each category of appliances, an algorithm for filtering the demand curve dedicated to said category of appliances, said algorithm being able to extract cycles of power variation from the digitalised demand curve, and to allocate it to said category of appliances;

- during the filtering of the digitalised demand curve:

  ○ - successively using the filtering algorithm dedicated to each category of appliances, to identify and to regroup using the digitalised demand curve, the cycles of power variation consumed by the electrical appliances;
  with the method being characterised on the one hand in that the digitalised demand curve is successively filtered using a specific algorithm for each category of appliances, according to an ordered succession of filtering algorithms, and with the method being characterised on the other hand in that the step of filtering per se of the digitalised demand curve for a given category of appliances comprises the following operations:

    - - searching and extracting from the demand curve, cycles of power variation characteristic of the given category of appliances;
    - - validating the cycles extracted according to the predefined power and time criteria, and distributing the cycles extracted between a set of valid cycles corresponding to the operating model in power and in time of an appliance, and a set of temporarily rejected cycles;
    - - creating of a temporary partition constituted of incomplete sub-sets of valid cycles, with each incomplete sub-set comprising cycles of a single appliance;
    - - local learning of valid cycles of each temporary partition, in such a way as to define characteristic criteria of the valid cycles;
    - - from the criteria coming from the local learning, reconstructing the complete or practically complete chronological operating model for each appliance, by attributing to it cycles of power variation that were previously temporarily rejected;
    - - updating of the classification of the learning according to the step of reconstruction, in such a way as to create a definitive partition of the extracted cycles, with each partition corresponding to the consumption of an appliance.

2. Method according to claim 1, **characterised in that** the step of searching and of extracting cycles of power variation characteristic of a given category of appliances, consists in defining characteristic binary codes corresponding to the power variations of this category of appliances, then in subtracting from the digitalised demand curve, the characteristic binary codes defined as such and in classifying them into a set of valid cycles corresponding to the operating model of an appliance, or into a set of temporarily rejected cycles, then in re-injecting the temporarily rejected cycles into the demand curve before searching for cycles of power variation pertaining to another category of appliances.

3. Method according to claim 1, **characterised in that** in order to validate the extracted cycles for a given category of appliances, the characteristics in terms of power and in time of the extracted cycles are compared to the predefined criteria in power and in time for this category, and those of the cycles that have characteristics in power and in time that are incompatible with the fixed criteria are temporarily rejected, the other cycles are definitively validated as belonging to an appliance of the given category.

4. Method according to claim 1, **characterised in that** the creating of a temporary partition comprised of incomplete sub-sets of valid cycles of power variation for each appliance comprises steps consisting in regrouping the valid cycles of power variation that have substantially the same values and criteria in power and in time, in such a way that each group of cycles represents the cycles of an appliance of the category having operated on the demand curve, then in representing the temporary partition in the form of a matrix of information where each line represents an appliance and each column contains the valid extracted cycles that belong to the appliances.

**5.** Method according to claim 1, **characterised in that** the step of learning consists in calculating the values of a set of criteria in power and in time associated with the valid cycles of each appliance, then in analysing these values statistically, and in storing the statistics obtained in memory, in the form of an information vector associated with each appliance.

**6.** Method according to claim 1, **characterised in that** the step of reconstructing consists, in reconstituting for each appliance, the complete or practically complete set of cycles of power variation for this appliance between from when it is turned on to when it is turned off, by chronologically integrating into the set of valid cycles of this appliance, cycles selected from the set of temporarily rejected cycles, with this selection being carried out using criteria and thresholds coming from the learning.

**7.** Method according to claim 1, **characterised in that** the step of creating a definitive partition consists in updating each sub-set of cycles representing an appliance of the filtered category, with the missing cycles such as reconstructed during the step of reconstructing.

**8.** Method according to any of claims 1 to 7, **characterised in that** the criteria in terms of power and time are self-adapting and vary from one demand curve to another.

**9.** Method according to claim 1, **characterised in that** it comprises a step consisting in aggregating the electrical consumption of each category of appliances using the definitive partition of the extracted cycles, in such a way as to produce a summary report that indicates the electrical consumption, or the proportion of electrical consumption, of the appliances of each category during an analysis period of the consumption.

**10.** Method according to claim 1, **characterised in that** the demand curve is digitalised by periods of time less than or equal to one second.

**11.** Method according to one of the preceding claims, **characterised in that** the set of predefined categories of appliances comprises at least one of the categories among the following:

- - the so-called electric pump category;
- - the so-called electrical resistance category;
- - the so-called microwave oven category;
- - the so-called large household electrical appliances category;
- - the category for other electrical appliances that do not fall under one of the preceding categories.

**12.** Method according to claim 11, **characterised in that** the so-called electrical pump category is defined by a consumed cycle of power variation comprising successively a first positive power variation, a second negative power variation, and a third negative power variation.

**13.** Method according to claim 11, **characterised in that** the so-called large household electrical appliances category is defined by a consumed cycle of power variation comprising successively at least four power variations, namely a first positive power variation, a second negative power variation, a third positive power variation and a fourth negative power variation.

**14.** Method according to claim 11, **characterised in that** the so-called microwave oven category is defined by four types of separate cycles of power variation, with the first cycle type comprising a positive power variation followed by a negative variation, with the second cycle type comprising two positive variations followed by a negative variation, with the third cycle type comprising a positive variation followed by two negative variations, and the fourth cycle type comprising two successions with each one comprised of a positive variation followed by a negative variation.

**15.** Method according to claim 11, **characterised in that** the so-called electrical resistance category is defined by a consumed cycle of power variation successively comprising a first positive power variation followed by a second negative power variation.

**16.** Method according to claim 15, **characterised in that** it successively implements the filtering algorithm pertaining to the pump category, then the filtering algorithm pertaining to the microwave ovens category, then the filtering algorithm pertaining to the large household category, then the filtering algorithm pertaining to the resistance category.

**17.** Method as claimed in any preceding claim, **characterised in that** the steps of acquiring the demand curve and of filtering the demand curve are carried out locally on the consumption site.

**18.** Method according to any of claims 1 to 17, **characterised in that** the step of acquiring the demand curve is carried out locally, and **in that** binary values that represent the demand curve are then transmitted to a remote processing centre where the steps of filtering the demand curve are carried out.

**19.** Device for treatment intended to be connected to the electrical power line of a consumption site, **characterised in that** it comprises software adapted to implement the method as claimed in any preceding claim.

**FIGURE 1**

**FIGURE 2**

Figure 2 : extrait de courbe de charge, enregistrée en temps réel sur une période approximative de seize heures.

**FIG. 3A : la classe « Pompe »**

**FIG. 3B :  la classe « Résistance »**

**FIG. 3C : la classe « micro-onde »**

**FIG. 3D : la classe « Gros électroménager »**

**FIGURE 4**

**FIGURE 5.1**

Traitement classe i — 67

Extraction de cycles caractéristiques classe i — 68

69

Informations sous-ensemble 1

Informations sous-ensemble 2

Informations sous-ensemble n

66

Partition provisoire des appareils

*Changement de classe à traiter*

Apprentissage — 70

Reconstruction des sous-ensembles et mise à jour — 71

Partition complète — 72

**FIGURE 5.2**

**FIGURE 5.3**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 1136829 B1

**Littérature non-brevet citée dans la description**

- **LESLIE K NORFORD et al.** Non-intrusive electrical load monitoring in commercial buildings based on steady-state and transient load-detection algorithms. *ENERGY AND BUILDINGS, LAUSANNE, CH,* 01 Janvier 1996